# NEUE EUROPÄISCHE PATENTSCHRIFT

(11) **EP 0 911 987 B2**
(45) Veröffentlichungstag und Bekanntmachung des Hinweises auf die Entscheidung über den Einspruch: **02.05.2012**
(45) Hinweis auf die Patenterteilung: 17.01.2007
(21) Anmeldenummer: 98112371.4
(22) Anmeldetag: 04.07.1998
(51) Int. Cl.: H04B 1/20, H04B 10/10

(54) **Ferngesteuerter Funkempfänger**
Remote controlled radio receiver
Radiorécepteur commandé à distance

(30) Priorität: 23.10.1997 DE 19746841
(43) Veröffentlichungstag der Anmeldung: 28.04.1999
(73) Patentinhaber: ROBERT BOSCH GMBH, 70442 Stuttgart (DE)
(72) Erfinder: Rychlak, Stefan, 31241 Ilsede (DE)

(56) Entgegenhaltungen:
- EP-A- 0 569 602
- EP-A- 0 683 574
- DE-A- 2 820 184
- US-A- 3 937 949

## Beschreibung

### Stand der Technik

Die Erfindung geht von einem elektrischen Gerät nach der Gattung des Hauptanspruchs aus.

Elektrische Geräte mit einer Gerätekappe und an der Gerätekappe angeordneten Bedienelementen sind beispielsweise im Bereich von Autoradios bekannt.

Ferner sind ebenfalls im Bereich der Autoradios auch elektrische Geräte bekannt, die mittels Infrarotsignalen fernbedienbar sind, wie beispielsweise das aus dem Blaupunktkatalog "Programm'96/'97; Sound und Fahrvergnügen pur. Mobile Kommunikation von Blaupunkt." bekannte Autoradio "New York RDM 127".

Die EP 0 569 602 A1 zeigt einen Signalempfänger, bei dem ein Fotoempfänger hinter einer Flüssigkristallanzeige angeordnet ist. Der Fotoempfänger dient dazu, ein Signal von einer Fernbedienung zu empfangen, das von der Fernbedienung durch die Flüssigkristallzelle hindurch gestrahlt wird. Als Signal wird ein optisches Signal in einem Wellenlängenbereich von 950 nm verwendet.

### Vorteile der Erfindung

Das erfindungsgemäße elektrische Gerät mit den Merkmalen des Hauptanspruchs hat demgegenüber den Vorteil, dass für den Empfang von Lichtsignalen einer Fernbedienung an der Gerätekappe des elektrischen Gerätes kein zusätzliches Fenster vorgesehen werden muss. Vielmehr wird ein Bedienelement als Fenster zur Lichtzuführung zu einem Lichtempfänger verwendet, so daß die Funktionalität dieses Bedienelementes erhöht wird und Platz an der Gerätekappe eingespart wird. Dadurch können die zur Bedienung des elektrischen Gerätes erforderlichen Bedienelemente übersichtlicher an der Gerätekappe angeordnet werden.

Durch die in den Unteransprüchen aufgeführten Maßnahmen sind vorteilhafte Weiterbildungen und Verbesserungen des im Hauptanspruch angegebenen elektrischen Gerätes möglich.

Besonders vorteilhaft ist es, daß das Bedienelement aus Filtermaterial gebildet ist, das nur Licht in einem vorgegebenen Wellenlängebereich, vorzugsweise dem Infrarot-Bereich, durchläßt und daß der Lichtempfänger als Photodiode für diesen Wellenlängenbereich ausgebildet ist. Auf diese Weise werden störende Lichteinflüsse aus Wellenlängenbereichen, die nicht für die Übertragung von Fernbedienungssignalen vorgesehen sind, verhindert.

Vorteilhaft ist auch, daß die Form und der Brechungsindex des Materials des Bedienelementes so gewählt sind, daß mindestens in einem vorgegebenen Raumwinkel in das Bedienelement einfallendes Licht an den Lichtempfänger weitergeleitet wird. Auf diese Weise läßt sich der Empfangswinkel optimieren und eine größere Ortsunabhängigkeit für den Lichtsender der Fernbedienung bei der Abgabe von Fernbedienungssignalen realisieren.

Ein weiterer Vorteil besteht auch darin, daß durch diese Maßnahme der Lichtempfänger nicht direkt an der Oberfläche der Gerätekappe angeordnet sein muß, sondern auch tiefer innerhalb der Gerätekappe vorgesehen sein kann, ohne daß der Empfangswinkel für die zu empfangenden Fernbedienungssignale verringert wird.

Vorteilhaft ist weiterhin, daß das Bedienelement als in konusförmiger, an der Gerätekappe beweglich gelagert montierter Joystick ausgebildet ist, wobei der Konus zur Gerätekappe hin verjüngt ist. Ein solcher Joystick vereinigt in sich sowohl die Eigenschaften eines multifunktionalen Bedienelementes, durch das weitere Bedienelemente eingespart werden können, und die Form-Eigenschaften, die einen möglichst großen Empfangswinkel für die Lichtsignale einer Fernbedienung ermöglichen.

Ein weiterer Vorteil besteht darin, daß der Lichtempfänger auf einer Leiterplatte angeordnet ist. Dadurch entfällt die Erfordernis einer eigenen Schnittstelle zwischen dem Lichtempfänger und dem elektrischen Gerät, so daß die Kosten für die Schnittstelle eingespart werden können.

### Zeichnung

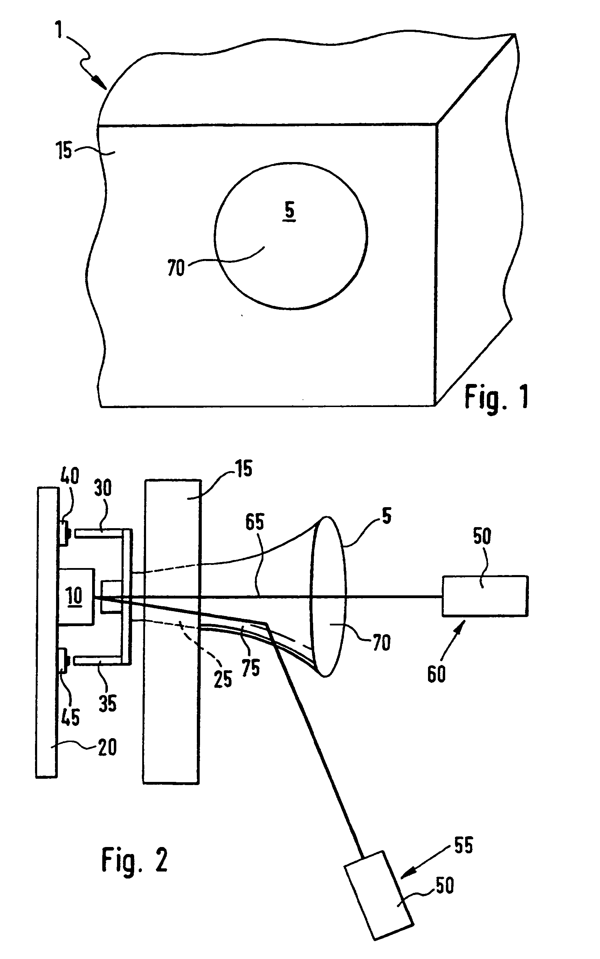

Ein Ausführungsbeispiel der Erfindung ist in der Zeichnung dargestellt und in der nachfolgenden Beschreibung näher erläutert. Es zeigen Figur 1 eine Vorderansicht eines elektrischen Gerätes mit Bedienelement und Figur 2 einen Querschnitt durch eine Anordnung mit einem lichtdurchlässigen Bedienelement und einem Lichtempfänger des elektrischen Gerätes.

### Beschreibung des Ausführungsbeispiels

In Figur 1 kennzeichnet 1 ein als Autoradio ausgebildetes elektrisches Gerät mit einer Gerätekappe 15, an der ein als Joystick ausgebildetes Bedienelement 5 angeordnet ist. Gemäß Figur 2, in der gleiche Bezugszeichen gleiche Elemente kennzeichnen, ist der Joystick 5 in etwa konusförmig ausgebildet, wobei der Konus zur Gerätekappe 15 hin verjüngt ist. In der Gerätekappe 15 ist eine Lagerung 25 vorgesehen, in der der Joystick 5 beweglich gelagert montiert ist. Die Lagerung ist dabei so ausgebildet, daß der Joystick 5 in beliebige oder vorgegebene Richtungen bewegt werden kann. Auf diese Weise lassen sich durch den Joystick 5 verschiedene Funktionen des Autoradios 1 auswählen, beispielsweise Lautstärke und Balance, bzw. für ausgewählte Funktionen Funktionswerte einstellen. So kann beispielsweise durch Bewegung des Joystick 5 nach links ein aus Sicht des Fahrers auf der linken Seite angeordneter Lautsprecher ausgewählt werden. Durch Bewegung des Joystick 5 nach rechts kann ein entsprechend auf der rechten Seite angeordneter Lautsprecher ausgewählt werden. Durch Bewegung des Joystick 5 nach unten kann die Lautstärke verringert, und durch Bewegung des Joystick 5 nach oben kann die Lautstärke erhöht werden. So führt eine Bewegung des Joystick 5 nach links oben beispielsweise zu einer Erhöhung der Lautstärke des auf der linken Seite angeordneten Lautsprechers. Zur Realisierung dieser Funktionen ist der Joystick 5 auf der dem Geräteinneren zugewandten Seite der Gerätekappe 15 mit Hebeln 30, 35 verbunden, die in Abhängigkeit der Bewegungsrichtung des Joystick 5 ausgelenkt werden. In der Querschnittsdarstellung nach Figur 2 ist ein oberer Hebel 30 und ein unterer Hebel 35 dargestellt. Dabei ist zu beachten, daß für jede mögliche Bewegungsrichtung des Joystick 5 ein entsprechender Hebel vorzusehen ist. Auf der der Gerätekappe 15 abgewandten Seite der Hebel 30, 35 ist im Innern des Autoradios 1 eine Leiterplatte 20 in einer Ebene in etwa parallel zur Gerätekappe 15 angeordnet. Auf der der Gerätekappe 15 zugewandten Seite der Leiterplatte 20 sind sogenannte Tipper 40, 45 vorgesehen, die jeweils mit einem der Hebel 30, 35 korrespondieren. Dabei korrespondiert ein oberer Tipper 40 mit dem oberen Hebel 30 und ein unterer Tipper 45 mit dem unteren Hebel 35. Für jede mögliche Bewegungsrichtung des Joystick 5 bzw. für jeden Hebel 30, 35 ist an der Leiterplatte 20 ein entsprechender Tipper 40, 45 vorzusehen, um die entsprechende Bewegung des Joystick 5 zur Auswahl der entsprechenden Funktion bzw. des entsprechenden Funktionswerts elektronisch umzusetzen. So wird durch Bewegung des Joystick 5 nach oben der obere Hebel 30 in Richtung zur Leiterplatte 20 geneigt, so daß er mit dem oberen Tipper 40 kontaktiert. Dadurch wird mittels einer beispielsweise auf der Leiterplatte 20 angeordneten Schaltung die gewünschte Funktion bzw. der gewünschte Funktionswert eingestellt. Entsprechendes gilt bei Bewegung des Joystick 5 nach unten, wodurch der untere Hebel 35 zur Leiterplatte 20 hin bewegt wird, so daß er den unteren Tipper 45 kontaktiert.

Auf der der Gerätekappe 15 zugewandten Seite der Leiterplatte 20 ist außerdem ein als Photodiode ausgebildeter Lichtempfänger 10 angeordnet, wobei die Photodiode 10 für den Empfang von Uchtsignalen in einem Infrarot-Wellenlängenbereich ausgebildet ist. Der Joystick 5 ragt auf der dem Gehäuseinneren zugewandten Seite der Gehäusekappe 15 in das Gehäuse des Autoradios 1 hinein. Die Position der Photodiode 10 auf der Leiterplatte 20 ist dabei so gewählt, daß sie direkt hinter dem Joystick 5 angeordnet ist. Dabei ist der Joystick 5 aus lichtdurchlässigem Material gebildet, so daß der Photodiode 10 über den Joystick 5 Licht zuführbar ist. Um Störeinflüsse aus Wellenlängenbereichen außerhalb des Infrarot-Bereiches zu verhindern, ist der Joystick 5 aus Filtermaterial gebildet, das nur Licht im Infrarot-Bereich durchläßt. Aufgrund der gewählten Konusform des Joystick 5 mit einem sich zur Gerätekappe 15 hin verjüngenden Konus wird Infrarot-Licht, das seitlich von einem Infrarot-Sender einer Fernbedienung 50 in einer ersten Position 55 gemäß Figur 2 auf eine Seitenfläche 75 des sich zur Gerätekappe 15 hin verjüngenden Konus des Joystick 5 abgestrahlt wird, an der Seitenfläche 75 zur Photodiode 10 hin gebrochen, so daß es über den Joystick 5 an die Photodiode 10 weitergeleitet und von dieser detektiert wird. Für eine Brechung des auf den Joystick 5 einfallenden Lichtes zur Gerätekappee 15 hin ist es Voraussetzung, daß das Licht in einem Winkel auf den Joystick 5 auftrifft, der zwischen einer optischen Achse 65, zu der der Joystick 5 rotationssymmetrisch ausgebildet ist, und dem Lot auf die Oberfläche des Joystick 5 am Auftreffpunkt des Lichtes aus der Sicht des vor der Gerätekappe 15 befindlichen Benutzers liegt. Bei geeignet gewähltem Brechungsindex des Materials des Joystick 5 wird für das einfallende Licht dann ein Brechungswinkel realisiert, der das Licht direkt auf die Photodiode 10 lenkt. Auf diese Weise legen die Form und der Brechungsindex des Joystick 5 den Raumwinkel fest, in dem in den Joystick 5 einfallendes Licht an die Photodiode 10 weitergeleitet wird. Gemäß einer zweiten Position 60 in Figur 2 ist die Fernbedienung 50 frontal vor dem Joystick angeordnet, so daß das vom Infrarot-Sender der Fernbedienung 50 abgestrahlte Licht in der optischen Achse 65 des Joystick 5 ohne Ablenkung direkt an die Photodiode 10 weitergeleitet wird. Dabei ist die dem Benutzer des Autoradios 1 zugewandte Oberfläche 70 des Joystick 5 im Querschnitt kreisförmig und nach außen, das heißt in Richtung vom Autoradio 1 weg in Form einer Sammellinse gewölbt. Somit wird das infrarot-Licht, das auf der Oberfläche 70 auftrifft, wie bei einer Sammellinse gesammelt und über den Joystick 5 der Photodiode 10 zugeführt.

Die Photodiode 10 wandelt die empfangenen Infrarot-Lichtimpulse in elektrische Impulse um, die dann einer weiteren Verarbeitung zugeführt werden. Auf diese Weise lassen sich Funktionen des Autoradios 1 über die Fernbedienung 50 auswählen und einstellen.

Die Erfindung ist nicht auf elektrische Geräte 1 mit einem Joystick 5 als Bedienelement beschränkt. Beispielsweise kann auch ein als Drehregler ausgebildetes Bedienelement 5 aus lichtdurchlässigem Material ausgebildet sein, um einem dahinterliegenden Lichtempfänger 10 Lichtsignale beispielsweise einer Fernbedienung 50 zuzuführen. Zur Vergrößerung des Raumwinkels, in dem einfallendes Licht durch das Bedienelement 5 an den Lichtempfänger 10 weitergeleitet wird, kann die Oberfläche des Bedienelementes 5 ebenfalls in Form einer Sammellinse ausgebildet sein. Zur Verhinderung von Störeinflüssen nicht gewünschter Wellenlängenbereiche können die entsprechenden Bedienelemente 5 ebenfalls aus geeignetem Filtermaterial hergestellt sein, das nur Licht in einem vorgegebenen Wellenlängenbereich, beispielsweise dem Infrarot-Wellenlängenbereich durchläßt.

Weiterhin ist die Erfindung nicht auf Autoradios beschränkt, sondern für alle elektrischen Geräte anwendbar, bei denen Funktionen mittels einer Fernbedienung auswählbar und/oder einstellbar sind und die ein geeignetes Bedienelement 5 aufweisen.

## Patentansprüche

1. Elektrisches Gerät (1) mit einem an einer Gerätekappe (15) angeordneten Bedienelement (5), wobei das Bedienelement (5) aus lichtdurchlässigem Material gebildet ist und wobei ein Lichtempfänger (10) in dem Gerät (1) so hinter dem Bedienelement (5) angeordnet ist, dass ihm über das Bedienelement (5) Licht zuführbar ist, wobei die Oberfläche (70) des Bedienelementes (5) in Form einer Sammellinse ausgebildet ist.

2. Elektrisches Gerät (1) mit einem an einer Gerätekappe (15) angeordneten Bedienelement (5), wobei das Bedienelement (5) aus lichtdurchlässigem Material gebildet ist und wobei ein Lichtempfänger (10) in dem Gerät (1) so hinter dem Bedienelement (5) angeordnet ist, dass ihm über das Bedienelement (5) Licht zuführbar ist, wobei das Bedienelement (5) als ein Joystick oder ein Drehregler ausgebildet ist.

3. Elektrisches Gerät (1) nach Anspruch 2, **dadurch gekennzeichnet, dass** der Joystick (5) in einer Lagerung (25) in der Gerätekappe (15) beweglich gelagert montiert ist.

4. Elektrisches Gerät (1) nach Anspruch 2 oder 3, **dadurch gekennzeichnet, dass** der Joystick (5) konusförmig ausgebildet ist, wobei der Konus zu der Gerätekappe (15) hin verjüngt ist.

5. Elektrisches Gerät (1) nach einem der vorherigen Ansprüche, **dadurch gekennzeichnet, dass** das Bedienelement (5) aus Filtermaterial gebildet ist, das nur Licht in einem vorgegebenen Wellenlängenbereich durchlässt und dass der Lichtempfänger (10) als Photodiode für diesen Wellenlängenbereich ausgebildet ist.

6. Elektrisches Gerät (1) nach einem der vorherigen Ansprüche, **dadurch gekennzeichnet, dass** der Lichtempfänger (10) auf einer Leiterplatte (20) angeordnet ist.

## Claims

1. Electrical appliance (1) having a control element (5) which is arranged on an appliance cap (15), with the control element (5) being formed from translucent material and with a light receiver (10) being arranged behind the control element (5) in the appliance (1) such that light can be supplied to it via the control element (5), wherein the surface (70) of the control element (5) is in the form of a convex lens.

2. Electrical appliance (1) having a control element (5) which is arranged on an appliance cap (15), with the control element (5) being formed from translucent material and with a light receiver (10) being arranged behind the control element (5) in the appliance (1) such that light can be supplied to it via the control element (5) wherein the control element (5) is in the form of a joystick or a rotation regulator.

3. Electrical appliance (1) according to Claim 2, **characterized in that** the joystick (5) is mounted in a bearing (25) in the appliance cap (15), supported such that it can move.

4. Electrical appliance (1) according to Claim 2 or 3, **characterized in that** the joystick (5) is conical, with the cone tapering towards the appliance cap (15).

5. Electrical appliance (1) according to one of the preceding claims, **characterized in that** the control element (5) is formed from filter material which allows light only in a predetermined wavelength range to pass through, and **in that** the light receiver (10) is in the form of a photodiode for this wavelength range.

6. Electrical appliance (1) according to one of the preceding claims, **characterized in that** the light receiver (10) is arranged on a predetermined circuit board (20).

## Revendications

1. Appareil électrique (1) comportant un élément de commande (5) disposé au niveau du boîtier d'un appareil (15), l'élément de commande (5) étant composé d'un matériau translucide, et un récepteur de lumière (10) étant disposé dans l'appareil (1) derrière l'élément de commande (5) de telle façon qu'il puisse recevoir lumière par le biais de l'élément de commande (5), la surface (70) de l'élément de commande (5) ayant la forme d'une lentille convergente.

2. Appareil électrique (1) comportant un élément de commande (5) disposé au niveau du boîtier d'un appareil (15), l'élément de commande (5) étant composé d'un matériau translucide, et un récepteur de lumière (10) étant disposé dans l'appareil (1) derrière l'élément de commande (5) l'élément de commande (5) étant une manette ou un bouton.

3. Appareil électrique (1) selon la revendication 2, **caractérisé en ce que** la manette (5) est montée supportée de manière mobile dans un logement (25) du boîtier d'appareil (15).

4. Appareil électrique (1) selon la revendication 2 ou 3, **caractérisé en ce que** la manette (5) est de forme conique, le cône s'effilant dans la direction du boîtier de l'appareil (15).

5. Appareil électrique (1) selon l'une des revendications précédentes, **caractérisé en ce que** l'élément de commande (5) est en un matériau filtrant ne laissant pénétrer que la lumière située dans une gamme de longueurs d'ondes prédéfinie et **en ce que** le récepteur de lumière (10) est une photodiode adaptée à cette gamme de longueurs d'ondes.

6. Appareil électrique (1) selon l'une des revendications précédentes, **caractérisé en ce que** le récepteur de lumière (10) est disposé sur un circuit imprimé (20).
